# FASCICULE DE BREVET EUROPEEN

(11) **EP 0 597 745 B1**
(45) Date de publication et mention de la délivrance du brevet: **07.04.1999**
(21) Numéro de dépôt: 93402582.6
(22) Date de dépôt: 20.10.1993
(51) Int. Cl.: G11C 17/16, H01L 23/525

(54) **Circuit à fusible, pour circuit intégré**
Sicherungsschaltung für integrierte Schaltung
Fusible circuit for integrated circuit

(30) Priorité: 29.10.1992 FR 9212969
(43) Date de publication de la demande: 18.05.1994
(73) Titulaire: GEMPLUS CARD INTERNATIONAL, F-13420 Gémenos (FR)
(72) Inventeur: Kowalski, Jacek, F-75116 Paris (FR)
(74) Mandataire: Schmit, Christian Norbert Marie

(56) Documents cités:
- EP-A- 0 161 947
- EP-A- 0 408 419
- US-A- 4 198 696

## Description

L'invention concerne les circuits intégrés, et plus particulièrement ceux qui comportent un ou plusieurs fusibles physiques.

Un fusible physique est un élément de circuit ayant une structure initiale que l'on peut détruire irréversiblement pour lui donner une structure finale de propriétés différentes. La structure initiale est par exemple isolante et la structure finale conductrice ou résistive; ou bien au contraire la structure initiale est conductrice ou résistive et la destruction du fusible consiste à le rendre isolant.

La destruction s'opère en général soit par un faisceau laser dirigé vers le fusible pour le faire fondre, soit par un circuit électrique de claquage apte à appliquer au fusible des conditions de courant et/ou tension qui modifient sa structure.

Un exemple de fusible est décrit dans la demande de brevet EP-A-0 408 419. Ce fusible est constitué par une couche isolante très mince entre deux conducteurs. Il est claqué par l'application d'une haute tension (de l'ordre de 20 volts) entre les conducteurs, avec un courant de quelques milliampères pendant quelques dizaines de millisecondes. La couche isolante devient alors résistive. L'état intact ou claqué du fusible est détecté par un circuit qui mesure le courant passant à travers le fusible. Ce circuit sert à commander d'autres éléments du circuit intégré dans lequel le fusible est inséré. Le fusible est par exemple utilisé pour condamner irréversiblement l'accès à une zone de mémoire non volatile dans le circuit intégré.

Ce type de fusible se rencontre fréquemment dans les cartes à puces. Bien que l'invention ne se limite pas aux fusibles pour circuits de cartes à puces, les cartes à puces illustrent un problème que l'on peut rencontrer à propos des fusibles : ces cartes sont minces et peuvent donc se tordre, entraînant des contraintes mécaniques sévères dans la puce de circuit intégré. Dans le cas du fusible indiqué ci-dessus, les contraintes peuvent aboutir à détruire la connexion résistive établie lors du claquage. Le fusible peut ainsi être remis dans un état voisin de son état intact, alors qu'il a été claqué d'une manière qui devrait être irréversible. Dans d'autres structures de fusibles, les contraintes peuvent engendrer le même genre de défauts : fusible claqué qui redevient équivalent à un fusible intact, ou fusible intact qui se comporte comme un fusible claqué.

Cette situation n'est pas acceptable, même si la probabilité qu'elle arrive est faible.

Pour améliorer la fiabilité des circuits intégrés à fusible physique, l'invention propose d'associer au fusible une cellule de mémoire non volatile programmable électriquement, la cellule étant programmée en même temps que le fusible est claqué. L'état du fusible est confirmé par l'état de la mémoire. En particulier, l'état claqué du fusible peut être confirmé par l'état programmé de la mémoire, dans les applications où ce qui importe c'est de s'assurer que le circuit peut continuer à conserver les fonctionnalités définies par l'état claqué du fusible. Si la structure claquée reprend ultérieurement plus ou moins les caractéristiques de la structure intacte, la cellule de mémoire suppléera le fusible défectueux.

Par conséquent, exprimé d'une autre manière, l'invention propose un circuit à fusible, comportant un fusible physique et un circuit de détection de l'état du fusible selon les caractéristiques de la revendication 1.

L'invention s'applique principalement aux fusibles claquables électriquement. Elle est particulièrement adaptée aux fusibles à claquage d'isolant.

Un circuit unique de claquage est de préférence prévu pour réaliser le claquage du fusible physique et la programmation de la cellule associée, avec un seul ordre de claquage.

Le circuit de claquage comporte de préférence un premier transistor relié entre une source de tension de claquage et le fusible, ce dernier étant relié par ailleurs à une masse, pour appliquer une tension de claquage au fusible physique; la cellule de mémoire est un transistor à grille flottante relié au fusible d'une part et à un transistor de commande d'autre part, ce dernier étant par ailleurs relié à la masse.

Le transistor de commande est rendu conducteur en dehors de la phase de programmation de la mémoire.

Le noeud commun reliant le fusible et le transistor à grille flottante est par ailleurs relié à un circuit de détection qui permet de détecter l'état du fusible. Ce circuit est de préférence un circuit de mesure de la somme des courants s'écoulant à travers le fusible et la cellule de mémoire.

D'autres particularités et avantages de l'invention apparaîtront à la lecture de la description qui est faite à titre illustratif et non limitatif à partir des dessins sur lesquels :
- la figure 1 représente un fusible à claquage d'oxyde;
- la figure 2 représente le fusible, sa cellule de mémoire associée et le circuit de claquage commun;
- la figure 3 représente des diagrames temporels associés à la figure 2.

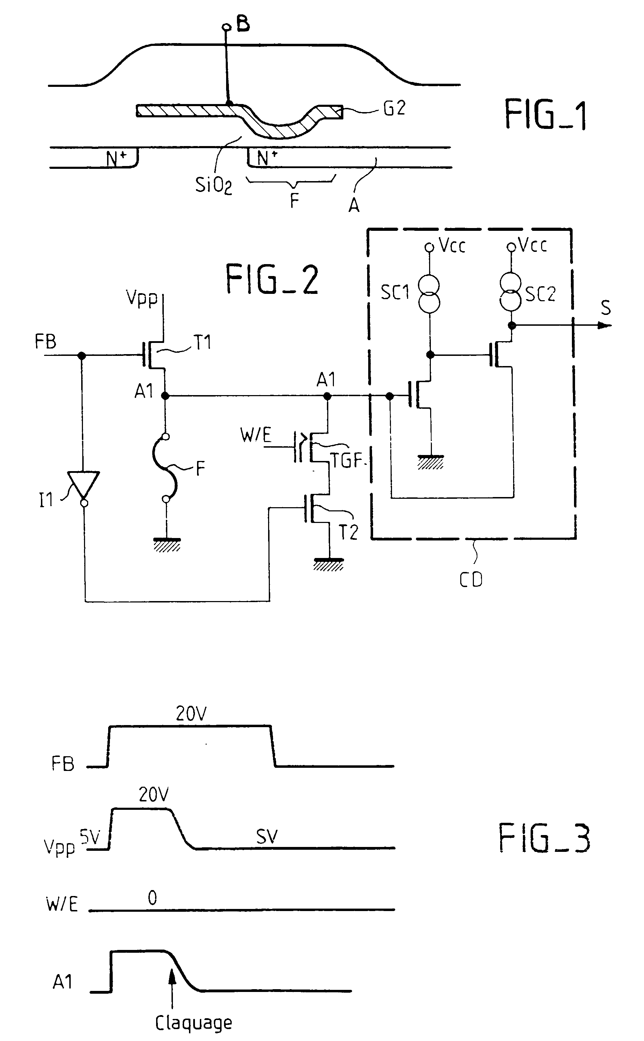

Un fusible auquel s'applique la présente invention est celui de la figure 1; le fusible F est constitué par deux conducteurs A et B séparés par une couche d'isolant localement amincie (épaisseur de l'ordre de 100 angströms (100 x 10⁻¹⁰ m) à l'endroit de l'amincissement). La couche isolante claque et devient résistive en présence d'un champ électrique suffisant (environ 20 volts entre les conducteurs A et B, correspondant à un champ électrique d'environ 20 millions de volts par cm).

Pour que le fusible soit facilement réalisable dans une technologie comportant des mémoires à transistors à grille flottante, le conducteur A est réalisé comme un drain de transistor à grille flottante, c'est-à-dire par une diffusion de type N+ dans un substrat semiconducteur monocristallin; le conducteur B est réalisé à partir de la grille G2 d'un transistor à grille flottante. La grille est en silicium polycristallin et forme le conducteur B. L'amincissement local d'oxyde se situe au dessus de la diffusion N+.

On pourrait bien entendu ici, avoir un transistor avec deux grilles en silicium polycristallin reliées électriquement pour former le conducteur B

D'autres détails sur ce fusible (qui n'est donné qu'à titre d'exemple) peuvent être trouvés dans le brevet EP-A-0 408 419 déjà cité.

La figure 2 représente un schéma du circuit de claquage et de détection associés à ce fusible, avec en outre le perfectionnement selon l'invention.

Le circuit de claquage le plus simple comprend un transistor T1 dont la source (noeud Al) est reliée au fusible F, lequel est par ailleurs connecté à la masse. Un ordre de claquage peut être donné en appliquant un signal de claquage FB à la grille de T1 tout en portant le drain de T1 à une tension de claquage suffisante Vpp.

Pour effectuer le claquage, on fait monter la tension Vpp d'une valeur normale faible (par exemple 5 volts) à une valeur plus élevée, par exemple une vingtaine de volts. Simultanément, on fait monter le signal FB de 0 à environ 20 volts. Le transistor T1 devient conducteur, la tension de 20 volts s'applique au fusible, le fusible claque, la tension à ses bornes chute à une valeur basse (par exemple 2 volts sur le noeud A1), et la tension Vpp chute alors en général à une valeur réduite du fait que la source de tension de claquage qui fournit Vpp ne peut guère fournir un courant de claquage élevé tout en maintenant sa valeur de 20 volts.

Un circuit de détection CD, relié au fusible F par le noeud A1, permet ensuite de détecter l'état claqué ou non claqué du fusible, ceci par mesure du courant consommé sur le noeud A1 : dans l'état intact aucun courant ne passe du noeud A1 vers la masse; dans l'état claqué, le fusible est résistif et un courant passe. Ce courant est détecté par le circuit CD; celui-ci fournit un signal logique sur sa sortie S selon l'existence d'un courant suffisant.

Avec l'invention, on prévoit en outre une cellule de mémoire non volatile pour confirmer l'état du fusible. L'état de cette cellule sera détecté par le même circuit de détection CD; dans le cas où le fusible ne passe plus suffisamment de courant malgré le fait qu'il a été claqué, il faut que la cellule de mémoire laisse passer un courant suffisant; le circuit de détection réagit alors comme si le fusible fonctionnait normalement.

Si le fusible est du type qui laisse passer un courant lorsqu'il est claqué, il faut connecter la cellule de mémoire de telle sorte qu'elle laisse aussi passer un courant et qu'elle soit montée en parallèle avec le fusible. Ceci en supposant bien sûr que l'état qu'on veut confirmer est l'état claqué et non l'état intact. On pourrait cependant aussi concevoir un circuit utilisant une cellule de mémoire qui est placée en série avec le fusible, dans le cas où le fusible est du type isolant dans l'état claqué (là encore pour que la cellule de mémoire confirme l'état claqué du fusible).

Dans l'exemple de réalisation décrit à la figure 2, on raccorde donc une cellule de mémoire TGF au noeud A1. Cette cellule est de préférence un transistor à grille flottante de type EEPROM qui peut être effacé ou programmé électriquement. Ce transistor est réalisé de préférence selon une technologie semblable à celle du fusible de la figure 1, les grilles G1 et G2 n'étant toutefois pas court-circuitées pour que la grille G2 reste flottante.

Le drain de ce transistor TGF est relié au noeud A1, la source est reliée à la masse par l'intermédiaire d'un transistor de commande T2, et la grille du transistor TGF peut être commandée notamment par un signal d'effacement W/E.

Le transistor T2 est normalement conducteur, sauf pendant l'opération simultanée de claquage du fusible et de programmation de la cellule mémoire. Sa grille est commandée par le complément logique du signal de claquage FB; un niveau logique de 0 à 5 volts suffit cependant pour commander T2. De manière symbolique, un inverseur I1 a été représenté entre le signal FB et la grille de T2.

L'opération de claquage est exécutée selon les diagrammes représentés à la figure 3. Le claquage du fusible F est identique à ce qui a été expliqué précédemment, c'est-à-dire que la présence de la cellule de mémoire TGF n'influe pas sur le claquage; les diagrammes de la figure 3 s'appliquent.

En ce qui concerne la grille du transistor TGF, elle est maintenue à 0 pendant le claquage (W/E = 0)

Pendant l'élévation de la tension Vpp jusqu'à une valeur d'environ 20 volts, le transistor TGF se programme, c'est-à-dire que des électrons sont extraits de sa grille flottante (on a pu éventuellement au préalable effacer le transistor, c'est-à-dire la charger en électrons, comme on le verra plus loin). Le transistor TGF est en effet dans des conditions de programmation : drain à 20 volts, source isolée par le transistor T2 non conducteur, grille à 0 volts. Comme la programmation du transistor à grille flottante s'opère en un temps (quelques millisecondes) plus bref que le claquage du fusible (5 à 20 millisecondes), cette programmation se fait avant que le potentiel du noeud A1 ne chute sous l'effet du claquage.

La cellule de mémoire est donc programmée simultanément avec le claquage du fusible, par un seul ordre de claquage FB.

Après programmation, le signal FB passe à zéro; le signal W/E est porté à une tension légèrement supérieure à 0 (de 1 à 5 volts) pour mettre la cellule dans des conditions de lecture. Toutefois, si l'opération de programmation a chargé la grille flottante suffisamment pour que le transistor TGF ait une tension de seuil négative, on peut laisser la tension W/E à 0.

Il circule alors un courant If dans le fusible F et un courant Im dans le transistor à grille flottante TGF.

La somme des courants If et Im est comparée, dans le circuit de détection CD, à un seuil Iref. Un signal logique indiquant un fusible intact est fourni sur la sortie S si la somme des courants est inférieure au courant Iref; un signal logique inverse indiquant un fusible claqué est fourni si la somme des courants est supérieure à ce seuil.

Le courant Iref est choisi tel que le signal de fusible claqué apparaisse lorsque la somme des courants mesurée est supérieure au courant nominal qui circule dans la cellule programmée.

Ceci veut dire que même si le fusible est devenu très résistif, le circuit de détection va encore détecter l'équivalent d'un fusible claqué. Si le claquage du fusible est destiné à valider un fonctionnement de circuit après diverses opérations de personnalisation, cela ne pose pas de problème particulier. Toutefois, il faudra en général qu'on puisse tester véritablement l'état du fusible au moins à certains moments (tels que avant la phase de personnalisation), et pour cela on prévoit d'effacer la cellule de mémoire TGF.

Pour effacer la cellule, on applique simplement une tension d'une vingtaine de volts sur la grille flottante, le transistor T2 étant conducteur (FB = 0).

Ensuite, la cellule ne laisse plus passer de courant et le circuit de détection va véritablement pouvoir vérifier si le fusible F est intact, et autoriser les opérations correspondantes dans le circuit (par exemple la mémorisation de données non accessibles dans le cas d'un circuit pour carte à puce). Ce n'est qu'après cette phase que l'on effectuera le claquage du fusible et la programmation simultanée de la cellule de mémoire.

## Revendications

1. Circuit à fusible, comportant un fusible physique (F), un circuit de détection de l'état du fusible (CD), et un circuit électrique de claquage du fusible (T1), commandable par un signal de commande de claquage (FB), caractérisé en ce qu'il comporte une cellule de mémoire non volatile programmable électriquement (TGF), associée au fusible et programmée lorsque le fusible est claqué, la cellule de mémoire étant connectée au circuit de détection et à un circuit de programmation (T2) recevant ce signal de commande de claquage, de manière à confirmer, lorsqu'elle est programmée, l'état claqué du fusible même si les caractéristiques du fusible claqué changent au cours du temps.

2. Circuit à fusible selon la revendication 1, caractérisé en ce que le fusible est un fusible isolant dans l'état intact, et conducteur ou résistif dans l'état claqué.

3. Circuit à fusible selon la revendication 2, caractérisé en ce que le fusible est un fusible à claquage d'isolant.

4. Circuit selon la revendication 1, caractérisé en ce que le circuit de claquage comporte un transistor (T1) relié entre une source de tension de claquage (Vpp) et le fusible, ce dernier étant par ailleurs relié à une masse.

5. Circuit selon des revendications 1 à 4, caractérisé en ce que la cellule de mémoire est constituée par un transistor à grille flottante (TGF).

6. Circuit selon la revendication 5, caractérisé en ce que le transistor à grille flottante est relié d'une part à une borne du fusible (A1) susceptible de recevoir une tension de programmation (Vpp), et d'autre part à un transistor de commande (T2) lui-même relié par ailleurs à la masse.

7. Circuit selon la revendication 6, caractérisé en ce que le transistor de commande est rendu conducteur en dehors d'une phase de claquage, pour relier le transistor à grille flottante à la masse, et reçoit à cet effet le complément d'un signal de commande de claquage (FB).

8. Circuit selon l'une des revendications 1 à 7, caractérisé en ce que le fusible et la cellule de mémoire sont connectées à un noeud (A1), en ce que le fusible laisse passer un courant de ce noeud vers la masse lorsqu'il est dans l'état claqué, en ce que la cellule de mémoire laisse passer un courant de ce noeud vers la masse lorsqu'elle est dans un état programmé, et en ce que le circuit de détection est connecté au noeud et comporte un circuit de mesure du courant consommé par le noeud.

## Claims

1. A fuse circuit, having a physical fuse (F), a circuit for detecting the state of the fuse (CD), and an electrical circuit for blowing the fuse (T1), which can be controlled by a blowing control signal (FB), characterised in that it includes an electrically programmable non-volatile memory cell (TGF), associated with the fuse and programmed when the fuse is blown, the memory cell being connected to the detection circuit and to a programming circuit (T2) receiving this blowing control signal, so as to confirm, when it is programmed, the blown state of the fuse even if the characteristics of the blown fuse change over time.

2. A fuse circuit according to Claim 1, characterised in that the fuse is a fuse which is insulating in the intact state, and conductive or resistive in the blown state.

3. A fuse circuit according to Claim 2, characterised in that the fuse is an insulant-blowing fuse.

4. A circuit according to Claim 1, characterised in that the blowing circuit includes a transistor (T1) connected between a blowing voltage source (Vpp) and the fuse, the latter also being connected to an earth.

5. A circuit according to Claims 1 to 4, characterised in that the memory cell consists of a floating gate transistor (TGF).

6. A circuit according to Claim 5, characterised in that the floating gate transistor is connected on the one hand to a terminal of the fuse (A1) able to receive a programming voltage (Vpp), and on the other hand to a control transistor (T2) itself also connected to earth.

7. A circuit according to Claim 6, characterised in that the control transistor is made conductive outside a blowing phase, in order to connect the floating gate transistor to earth, and for this purpose receives the complement of a blowing control signal (FB).

8. A circuit according to one of Claims 1 to 7, characterised in that the fuse and memory cell are connected to a node (A1), in that the fuse allows a current to pass from this node to earth when it is in the blown state, in that the memory cell allows a current to pass from this node to earth when it is in a programmed state, and in that the detection circuit is connected to the node and includes a circuit for measuring the current consumed by the node.

## Patentansprüche

1. Sicherungsschaltkreis mit einer physikalischen Sicherung (F), einem Detektionskreis des Sicherungszustands (CD) und einem Durchschlagstromkreis der Sicherung (T1), der von einem Durchschlagsteuersignal (FB) gesteuert werden kann, dadurch gekennzeichnet, dass er eine elektrisch prcgrammierbare nicht flüchtige Speicherzelle (TGF) umfasst, die der Sicherung zugeordnet ist und programmiert wird, wenn die Sicherung durchgeschlagen ist, wobei die Speicherzelle am Detektionskreis und an einen Programmierkreis (T2) angeschlossen ist, der dieses Durchschlagsteuersignal empfängt, so dass sie, wenn sie programmiert ist, den durchgeschlagenen Zustand der Sicherung bestätigt, selbst wenn sich die Merkmale der durchgeschlagenen Sicherung im Laufe der Zeit ändern.

2. Sicherungsschaltkreis nach Anspruch 1, dadurch gekennzeichnet, dass die Sicherung im heilen Zustand eine isolierende und im durchgeschlagenen Zustand eine leitende oder resistive Sicherung ist.

3. Sicherungsschaltung nach Anspruch 2, dadurch gekennzeichnet, dass die Sicherung eine Sicherung mit Isolationsdurchschlag ist.

4. Schaltung nach Anspruch 1, dadurch gekennzeichnet, dass der Durchschlagkreis einen Transistor (T1) enthält, der zwischen einer Durchschlagspannungsquelle (Vpp) und der Sicherung angeschlossen ist, wobei die letztere weiters an einer Masse liegt.

5. Schaltkreis nach Ansprüchen 1 bis 4, dadurch gekennzeichnet, dass die Speicherzelle aus einem Transistor mit offenem Gate (TGF) besteht.

6. Schaltkreis nach Anspruch 5, dadurch gekennzeichnet, dass der Transistor mit offenem Gate einerseits an eine Klemme der Sicherung (Al) angeschlossen ist, die mit einer Programmierspannung (Vpp) beaufschlagt werden kann, und andererseits an einen Steuertransistor (T2), der seinerseits an Masse liegt.

7. Schaltkreis nach Anspruch 6, dadurch gekennzeichnet, dass der Steuertransistor ausserhalb einer Durchschlagsphase leitend gemacht wird, um den Transistor mit offenem Gate mit der Masse zu verbinden, und er hierfür die Ergänzung eines Durchschlagsteuersignals (FB) erhält.

8. Schaltkreis nach einem der Ansprüche 1 bis 7, dadurch gekennzeichnet, dass die Sicherung und die Speicherzelle an einem Knoten (AJ) angeschlossen sind, dass die Sicherung einen Strom dieses Knotens zur Masse hin durchlässt, wenn sie sich in durchgeschlagenem Zustand befindet, dass die Speicherzelle einen Strom dieses Knotens zur Masse hin durchlässt, wenn sie sich in einem programmierten Zustand befindet, und dass der Detektionskreis am Knoten angeschlossen ist und einen Messkreis des vom Knoten verbrauchten Stroms umfasst.
